# EUROPEAN PATENT APPLICATION

(11) **EP 2 001 059 A2**
(43) Date of publication of application: **10.12.2008**
(21) Application number: 08010061.3
(22) Date of filing: 02.06.2008
(51) Int. Cl.: H01L 33/00

(54) **LED chip production method**

(30) Priority: 08.06.2007 JP 2007152459
(71) Applicant: USHIODENKI KABUSHIKI KAISHA, Chiyoda-ku 100 Tokyo (JP)
(72) Inventor: Imai, Yuji, Ushio Lighting Inc., Kanzaki-gun, Hyogo-ken (JP)
(74) Representative: Tomerius, Isabel

(57) **Abstract**

An LED chip production method in which the sapphire substrate used in the process for formation of a nitride semiconductor can be easily and efficiently removed. The LED chip production method is a method for LED chips that has at least one nitride semiconductor layer. An LED chip structure assembly with a construction in which a nitride buffer layer is formed on the sapphire substrate and the at least one nitride semiconductor layer is formed on the nitride buffer layer which is then subjected to a chemical etching process to remove the nitride buffer layer, thereby facilitating removal of the sapphire substrate.

## Description

### Background of the Invention

### Field of Invention

This invention concerns an LED chip production method.

### Description of Related Art

LED devices in which an LED chip having nitride semiconductor layers is bonded to an exoergic member have come to be used in recent years in display equipment and lighting equipment, but in equipment using such LED chips as constituent members of the light source, problems have arisen in that it is difficult to increase luminance because heat generated by the LED chips builds up.

One cause cited for that problem is that a certain type of LED chip having nitride semiconductor layers has a structure with the nitride semiconductor layers stacked on a sapphire substrate and that sapphire, the constituent material of the substrate, has a low index of thermal conductivity.

In order to form a nitride semiconductor layer substrate during production of the LED chips, however, it is necessary to use a sapphire substrate as the substrate in connection with the nitride semiconductor layer to be formed, and specifically, from the perspective of the lattice constant. Chips with the sapphire substrate removed, moreover, have not been developed as a commercial product.

Thus, methods have been proposed to remove the sapphire substrate itself from structure assemblies constituted by forming nitride semiconductor layers on a sapphire substrate by chemical etching using an etchant that is a mixture of phosphates and sulfates to dissolve the sapphire (see, Japanese Pre-grant Patent Publication 2001-284314 and corresponding U.S. Patent Application Publication 2001-026950).

However, in such methods, etching proceeds at a slow pace because there is no etching stop layer and sapphire does not have good solubility, and the etching treatment must be performed with time management that is based on the speed of etching. Therefore, there are problems in that the LED chips cannot be produced efficiently and the treatment itself is not easy.

Here, according to Japanese Pre-grant Patent Publication 2001-284314 and corresponding U.S. Patent Application Publication 2001-026950, if the phosphate and the sulfate are mixed in a 1:2 ratio and a mixed solution at a temperature of 350 °C is used as the etchant, it takes some 120 minutes of the treatment to remove a sapphire substrate 300 µm thick.

### Summary of the Invention

This invention is based on the situation described above, and has the purpose of providing an LED chip production method in which the sapphire substrate used in the process for formation of a nitride semiconductor can be easily and efficiently removed.

### [Means to Solve the Problem]

The LED production method of this invention is an LED chip production method for production of LED chips as claimed in claim 1. Preferred process steps are described in the dependent claims. 8. In particular, the invention relates to an LED chip production method for production of LED chips wherein the nitride buffer layer having at least one nitride semiconductor layer, in which an LED chip structure assembly with a construction in which a nitride buffer layer is formed on the sapphire substrate and the at least one nitride semiconductor layer is formed on the nitride buffer layer is subjected to a chemical etching process to remove the nitride buffer layer by means of chemical etching.

In the LED chip production method of this invention, the thickness of the nitride buffer layer in the LED chip structure assembly is preferably from 20 to 300 nm.

In the LED chip production method of this invention, the at least one nitride semiconductor layer in the LED chip structure assembly preferably has a structure with an n-type semiconductor layer of n-GaN, a light-emitting layer of InGaN, and a p-type semiconductor layer of p-GaN, stacked in that order, the thickness of the n-type semiconductor layer stacked on the nitride buffer layer being from 50 to 100 µm.

In the LED chip production method of this invention, a handling plate is preferably adhered atop the at least one nitride semiconductor layer of the LED chip structure assembly subjected to the chemical etching process by means of an adhesive having oxidation resistance and alkali resistance.

Using the LED chip production method of this invention, for an LED chip structure assembly having a structure in which a nitride buffer layer and nitride semiconductor layers are stacked in that order on a sapphire substrate, the sapphire substrate is removed from the at least one nitride semiconductor layer, not by chemical etching of the sapphire substrate itself, which is made of sapphire that has little solubility in the solvents, but by chemical etching of the nitride buffer layer which comprises a material that has, relative to sapphire, great solubility in the solvents. By this means, it is possible to remove the sapphire substrate easily and in a short period, and so it is possible to remove the sapphire substrate used in formation of the nitride semiconductor layers easily and efficiently.

Further, in the LED chip production method of this invention, it is possible to remove the sapphire substrate from the at least one nitride semiconductor layer in the chemical etching process, and so during chip dicing there is no need for special machining to cut the sapphire substrate that is very hard and is not easy to cut. It is possible, therefore, to prevent deleterious effects, such as reduced yield, caused by special machining to cut the sapphire substrate.

Further, in the LED chip production method of this invention, LED chips having a structure with no sapphire substrate can be obtained whether or not a sapphire substrate is used in formation of the nitride semiconductor layers, and so LED chips that lack the deleterious effects caused by sapphire substrates with poor thermal conductivity and that have superior heat-resistance and thermal conductivity can be obtained. Consequently, the LED chips are suitable to use as constituent materials in light sources for display equipment and lighting equipment, for example.

This invention is explained in detail below.

### Brief Description of the Drawings

Figure 1 is an explanatory drawing that shows the construction of the LED chip produced by the LED chip production method of this invention.

Figure 2 is an explanatory drawing that shows an example of the construction of the LED chip structure assembly produced by the LED chip production method of this invention.

Figure 3 is an explanatory drawing that shows a treatment assembly to be chemically etched constituted by forming an adhesive layer and fixing a handling plate atop the LED chip structure assembly of Figure 2.

Figure 4 is an explanatory drawing that shows a chemical etching treated assembly produced by removing the nitriding buffer layer and sapphire substrate from the treatment assembly to be chemically etched of Figure 3.

Figure 5 is an explanatory drawing that shows an LED chip structure assembly constituted by removing the handling plate from the chemical etching treated assembly of Figure 4.

Figure 6(a) is an is an explanatory drawing that shows one example of the LED chip produced by the LED chip production method of this invention in the state when a metallic resource film for bond formation is formed on the bottom layer of the LED chip; and Figure 6(b) is an explanatory drawing showing the state when the LED chip of Figure 6(a) is bonded onto an exoergic member.

Figure 7(a) is an explanatory drawing that shows another example of the LED chip produced by the LED chip production method of this invention in the state when a metallic resource film for bond formation is formed on the bottom layer of the LED chip; Figure 7(b) is an explanatory drawing showing the state when the LED chip of Figure 7(a) is bonded onto an exoergic member, Figure 7(c) is an explanatory drawing showing the state when the LED chip is bonded onto the exoergic member in Figure 7(b) as seen from above.

### Detailed Description of the Invention

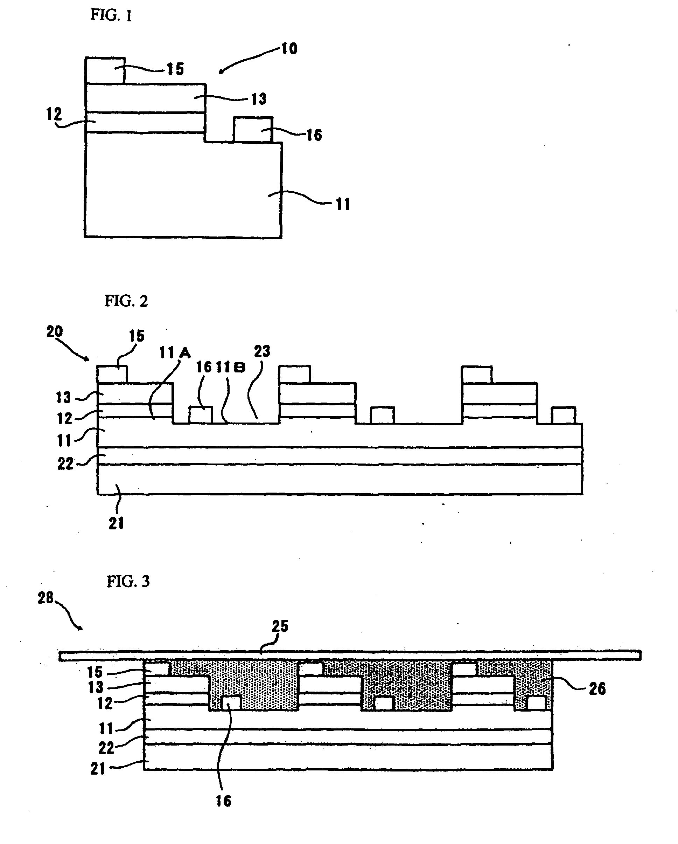

In the LED chip production method of this invention, an LED chip structure assembly with a construction in which a nitride buffer layer is formed on the sapphire substrate and the nitride semiconductor layer is formed on the nitride buffer layer is subjected to a chemical etching process to remove the nitride buffer layer by means of chemical etching; the LED chip obtained from this production method comprises nitride semiconductor layers with no sapphire substrate, as shown in Figure 1.

The LED chip shown in Figure 1 is a blue light-emitting LED chip. It has nitride semiconductor layers that comprise an n-type semiconductor layer 11 of n-GaN (gallium nitride), a light-emitting layer 12 of InGaN, and a p-type semiconductor layer 13 of p-GaN, stacked in that order; the n-type semiconductor layer 11 has a stepped upper surface (upward in Figure 1), on the lower step of which is formed an n electrode 16 made of, for example, an AuGe alloy (gold-germanium alloy) film, a Ni (nickel) film and an Au (gold) film. The light-emitting layer 12 and the p-type semiconductor layer 13 are stacked on the upper step, and a p electrode 15 made of, for example, a Ti (titanium) film, a Pt (platinum) film, and an Au film is formed on the upper surface (upward in Figure 1) of the p-type semiconductor layer 13.

The method of producing the LED chip of Figure 1, as a specific example of the LED chip production method of this invention, is explained below in detail.

### <Chemical etching preparatory process>

First, a nitride buffer layer (also called the "buffer layer" hereafter) is formed over the full upper surface (upward in Figure 2) of a sapphire substrate 21 with a thickness of 300 µm, and a LED chip structure assembly 20 is prepared having a structure in which nitride semiconductor layers comprising an n-type semiconductor layer of n-GaN, a light-emitting layer of InGaN, and a p-type semiconductor layer of p-GaN are stacked in that order on the upper surface (upward in Figure 2) of the buffer layer 22.

The LED chip structure assembly 20 in this example has multiple (three) projections 11A and recesses 11B formed alternating on the upper surface of the n-type semiconductor layer 11; light-emitting layers 12 and p-type semiconductor layers 13 are stacked on each convexity 11A, by which means separation slots 23 are formed. At the base of each separation slots 23, that is, on the upper surface of each concavity 11 =B, an electrode 16 is formed, and a p electrode 15 is formed on the upper surface (upward in Figure 2) of each p-type semiconductor layer 13.

The buffer layer 22 of the LED chip structure assembly 20 is made of aluminum nitride, for example.

Further, the thickness of the buffer layer 22 is preferably 20 nm to 300 nm; from the perspective of dissolving it in the chemical etching process, a thickness of 100 nm to 300 nm is particularly preferable. If the thickness of the buffer layer 22 were less than 20 nm, penetration of the etchant would be inadequate, and etching quality would be poor. If it were to exceed 300 nm, on the other hand, there would be a likelihood of a surface distribution of the etching because of the great thickness, and productivity would be liable to deteriorate.

The thickness of the n-type semiconductor layer 11 is preferably from 50 to 100 µm, and from 70 to 90 µm is particularly preferable.

If the thickness of the n-type semiconductor layer 11 were less than 50 µm, the LED substrate would be too thin and handling after removal of the handling plate would become difficult. If it were to exceed 100 µm, on the other hand, there would be a likelihood that the thermal conductivity of the layer and the thermal characteristics of the LED device would be liable to deteriorate because of the thickness.

As examples of the thickness of the light-emitting layer 12 and the p-type semiconductor layer 13 among the nitride semiconductor layers of the LED chip structure assembly 20, the thickness of the light-emitting layer 12 is 2.5 nm, for example, and that of the p-type semiconductor layer 13 is 210 nm, for example.

An LED chip structure assembly of this sort can be obtained by, for example, forming a buffer layer 22 on the full upper surface of a sapphire substrate by a suitable method, forming nitride semiconductor layers comprising an n-type semiconductor layer of n-GaN, a light-emitting layer of InGaN, and a p-type semiconductor layer of p-GaN, stacked in that order on the full surface of the buffer layer 22 by the epitaxial crystal growth method, and then using suitable methods to expose a portion of the n-type semiconductor layer 11 and form the separation slot 23 by removing, in the region where the separation slot 23 is to be formed, the p-type semiconductor layer 13, the light-emitting layer 12, and a portion of the n-type semiconductor layer 11, after which the p electrode 15 and the n electrode 16 are formed by suitable methods on the p-type semiconductor layer 13 and the n-type semiconductor layer 11 respectively.

Next, a handling plate 25 that comprises a blue glass substrate with a greater diameter than the sapphire substrate of the LED chip structure assembly 20-that is, with a surface area greater than that of the upper surface of the LED chip structure assembly-and a thickness of 500 µm, for example, is prepared, and the handling plate 25 is fixed in place by adhering it to the upper surface of an adhesive layer 26 that is formed by coating the upper surface (upward in Figure 3) of the LED chip structure assembly 20-that is, the full upper surface of the nitride semiconductor layers-with an adhesive having oxidation resistance and alkali resistance (also called an "oxidation resistance/alkali resistance adhesive" hereafter) so as to cover the p electrode 15 and the n electrode 16 on the upper surface of the nitride semiconductor layers, as shown in Figure 3.

As the oxidation resistance/alkali resistance adhesive that is the constituent material of the adhesive layer 26, one that is transparent and not photosensitive and that has good flatness and gas resistance is preferred. It is possible to use "FSC" (made by Shipley), for example.

The thickness of the adhesive layer is preferable from 0.5 to 20 µm. If the thickness of the adhesive layer were less than 0.5 µm, adhesion would be poor and peeling would be too easy, but if it exceeded 20 µm, adhesion would be too great and peeling would become difficult.

The term "thickness of the adhesive layer" here, in the event that the LED chip structure assembly 20 has an uneven upper surface as shown in Figure 3, means the minimum thickness (in Figure 3, this is the thickness of the adhesive layer formed atop the p electrode 15).

### Chemical etching process

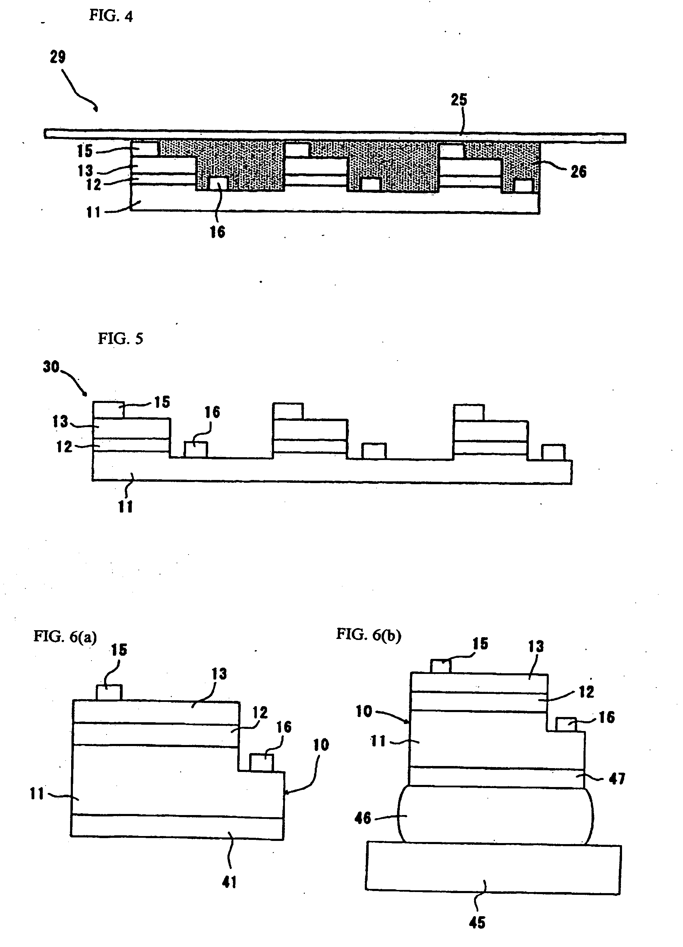

Then, chemical etching of the LED chip structure assembly 20 is done in the treatment assembly to be chemically etched 28 that is constituted by fixing the handling plate 25 to the LED chip structure assembly 20 with the adhesive layer 26, by which means the buffer layer 22 of the LED chip structure assembly 20 is etched. As this buffer layer 20 is etched, the sapphire substrate 21 is removed from the buffer layer 22 and the LED chip structure assembly 20. As a result, a chemical etching treated assembly 29, constituted as the treatment assembly to be chemically etched 28 with the buffer layer 22 and the sapphire substrate 21 removed, as shown in Figure 4, is obtained.

The etchant is selected as appropriate to the constituent material of the buffer layer 22 to be chemically etched, but if the buffer layer 22 consists of aluminum nitride, for example, such things as a potassium hydroxide (KOH) solution or a sodium hydroxide (NaOH) solution can be used.

Further, if as a potassium hydroxide (KOH) solution and a sodium hydroxide (NaOH) solution are used, the concentration can be from 5 to 99 vol%, diluted with distilled water, or the concentration can be 100 vol%.

As for the etching treatment conditions, the etching temperature is from normal temperature (25 °C) to 50 °C; the etching treatment period depends on the constituent material and thickness of the buffer layer 22 and the type and concentration of the etchant, but in the event that buffer layer 22 is aluminum nitride and its thickness is 20 nm, using a 100 % potassium hydroxide solution as the etchant, the period is from 5 to 20 seconds.

The buffer layer 22 in the treatment assembly to be chemically etched 28 is etched little-by little, proceeding from the exposed side face (the vertical face in the plane of the paper and the left and right faces of the buffer layer 22 of the treatment assembly to be chemically etched 28 shown in Figure 3) inward (in the direction perpendicular to the plane of the paper and in the left and right directions in Figure 3).

### Post-chemical-etching treatment process

The chemical etching treated assembly 29 obtained in this way is heat treated and then it is washed with an organic solvent such as acetone to remove residue of the adhesive layer 26 and peel off the handling plate 25. By this means, an LED chip connected assembly 30, with the buffer layer 22 and the sapphire substrate removed as shown in Figure 5, is obtained from the LED chip structure assembly 20.

As for the heat treatment conditions, the heating temperature is from 50 °C to 200 °C, for example, and the heating period is normally 1 minute when the heating temperature is 200 °C, for example.

The organic solvent washing treatment is done at normal temperature for 5 minutes, for example.

### Chip dicing process

The LED chip connected assembly 30 obtained in this way is cut and separated, by such means as a nickel blade, through the n-type semiconductor layer 11 in the separation slot 23 along one side face (the left side face in Figure 5) of the light-emitting layer 12 and the p-type semiconductor layer 13 that are stacked on the convexity 11A of the n-type semiconductor layer 11, and LED chips 10 are produced.

Using the LED chip production method of this invention, for a LED chip structure assembly 20 having a structure in which a buffer layer 22 and nitride semiconductor layers are stacked in that order on a sapphire substrate 21, the sapphire substrate 21 is removed from the nitride semiconductor layers, not by chemical etching of the sapphire substrate 21 itself, which is made of sapphire that has little solubility in the solvents, but by chemical etching of the buffer layer 22 which comprises a material that has, relative to sapphire, great solubility in the solvents. By this means, it is possible to remove the sapphire substrate 21 easily and in a short period, and so it is possible to remove the sapphire substrate 21 used in formation of the nitride semiconductor layers easily and efficiently.

In this LED chip production method, moreover, because of the great thickness of the buffer layer 22 and the n-type semiconductor layer 11 among the nitride semiconductor layers, the n-type semiconductor layer 11 adjacent to the buffer layer 22 is not greatly affected in the process of chemical etching of the LED chip structure assembly 20; it is possible to etch the buffer layer 22 alone.

Now, in the LED chips that have a structure with a nitride buffer layer and nitride semiconductor layers stacked in that order on a sapphire substrate that are well known in the prior art, the thickness of the n-type semiconductor layer among the nitride semiconductor layers is normally about 5 µm and the thickness of the nitride buffer layer is normally from 50 nm to 100 nm.

In this LED chip production method, moreover, because the LED chip connected assembly 30 that is subject to the chip dicing process does not have a sapphire substrate, there is no need to use special machining-a diamond cutting tool, for example-to cut the sapphire substrate 21 that is very hard and not easily cut; something like a nickel blade is ideally suited, and so it is possible to prevent deleterious effects such as a reduced yield caused by use of a diamond cutting tool, and it is possible to shorten the period needed for chip dicing.

Furthermore, by means of such an LED chip production method it is possible to obtain LED chips 10 having a structure that does not include a sapphire substrate, even though a sapphire substrate was used in formation of the nitride semiconductor layers, and so the LED chips 10 will not have the deleterious effects caused by having a sapphire substrate with poor thermal conductivity; they will have superior heat resistance and thermal conductivity. Therefore, LED devices constituted by bonding these LED chips 10 on exoergic members can be used as light sources for display equipment and lighting equipment, for example.

The LED chip without a sapphire substrate that is obtained by the LED chip production method of this invention can have, as shown in Figure 6(a), a metallic resource film 41 for bond formation formed on the lower surface (downward in Figure 6(a)) of the n-type semiconductor layer 11 among the nitride semiconductor layers; it can be bonded by means of an alloy layer 46 that is formed by the metallic resource film 41 for bond formation and a metallic resource film for bond formation that is formed that is formed on the upper surface of the exoergic member 45, by which means it becomes an LED device.

A barrier metal layer 47 is formed by the metallic resource film 41 together with the bond layer 46.

In the LED chip production method of this invention, something that corresponds to the structure of the LED chip to be formed is prepared as the LED chip structure assembly, by which means it is possible to produce LED chips having various structures.

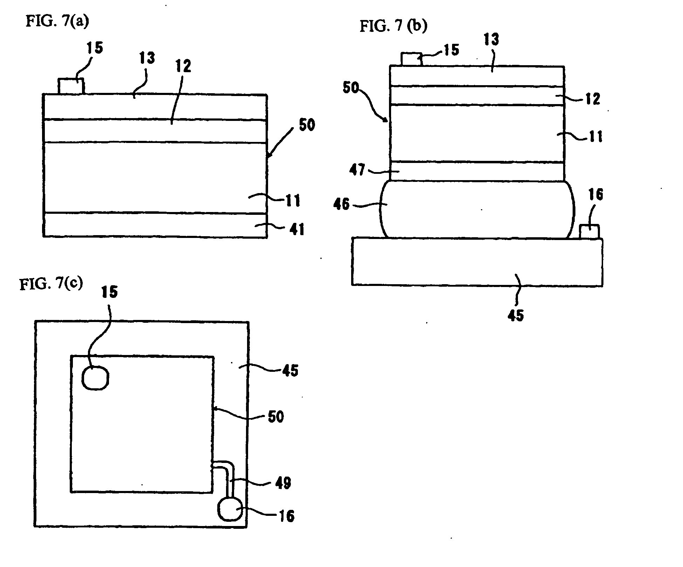

For example, it is possible to produce an LED chip, as shown in Figure 7(a), in which there is only a p electrode 15 rather that a structure with both an n electrode and a p electrode; the n electrode 16 can instead be located on the exoergic member 45 to be bonded, as shown in Figure 7(b).

In Figures 7(a) & 7(b), the LED chip 50 is one that does not require an n electrode 16 on the n-type semiconductor layer 11, and so it has a structure in which the light-emitting layer 12 and the p-type semiconductor layer 13 are stacked, in that order, on the full upper surface of the n-type semiconductor layer 11. Further, the p electrode 15 is located atop the p-type semiconductor layer 13.

In an LED device that has an LED chip 50 with such a construction as a constituent member, the LED chip 50 is electrically connected to an n electrode 16 by means of a metal pattern 49, comprising aluminum or another metal, for example, that is formed on the upper surface of the exoergic member 45 to which the LED chip 50 is bonded.

### [Embodiments]

A specific embodiment of this invention is explained below, but the invention is not limited by that.

### [Embodiment 1]

First, an LED chip structure assembly having the structure shown in Figure 2 was prepared as follows: a nitride buffer layer comprising aluminum nitride with a thickness of 300 nm was formed on a sapphire substrate 300 µm thick; nitride semiconductor layers comprising an n-type semiconductor layer of 70 µm of n-GaN, a light-emitting layer of 2.5 nm of InGaN, and a p-type semiconductor layer of 210 nm of p-GaN were stacked in that order on the nitride buffer layer; a p electrode comprising a Ti film, a Pt film, and an Au film was formed on the p-type semiconductor layer; and an n electrode comprising an AuGe alloy film, an Ni film, and an Au film was formed on the n-type semiconductor layer that constitutes the base of the separation slot.

Further, a handling plate was prepared that was comprised of a blue glass substrate 500 µm thick with a diameter greater than those of the LED chip structure assembly and the sapphire substrate of the LED chip structure assembly, and an area greater than that of the upper surface of the LED chip structure assembly.

Next, the upper surface of the nitride semiconductor layers of the LED chip structure assembly was coated with the oxidation resistance/alkali resistance adhesive "FSC" (made by Shipley Co.) to cover the p electrode and the n electrode, by which means an adhesive layer with a thickness of 10 µm above the p electrode was formed; by adhering and fixing the handling plate onto the adhesive layer, a treatment assembly to be chemically etched was fabricated (see Figure 3).

The treatment assembly to be chemically etched thus obtained was soaked in an etchant that comprised a 100 % potassium hydroxide solvent solution, and the nitride buffer layer was chemically etched at an etching treatment temperature of 25 °C.

The nitride buffer layer was dissolved in a 20 minute period of etching treatment; the nitride buffer layer was removed by this means and the sapphire substrate was removed at the same time (see Figure 4).

Then, the chemical etching treated assembly, which was the treatment assembly to be chemically etched from which the nitride buffer layer and the sapphire substrate had been removed, was subjected to heat treatment at a heat treatment temperature of 200 °C for a heat treatment period of 1 hour, and then to a washing treatment in acetone at normal temperature for 5 minutes. By this means, an LED chip connected assembly, which was the LED chip structure assembly with the buffer layer and the sapphire substrate removed, was obtained (see Figure 5).

The LED chip connected assembly obtained in this way was cut and separated, using a nickel blade, through the n-type semiconductor layer in the separation slot along one side face of the light-emitting layer and the p-type semiconductor layer that were stacked on the convexity of the n-type semiconductor layer, and LED chips were obtained. These LED chips were checked, and there had been no chipping.

This invention is not limited to the embodiments described above; various changes may be added.

## Claims

1. An LED chip production method for production of LED chips having nitride semiconductor layers, comprising the steps of:
producing an LED chip structure assembly in which a nitride buffer layer is formed on a sapphire substrate and at least one nitride semiconductor layer is formed on the nitride buffer layer, and removing the nitride buffer layer by subjecting the nitride buffer layer to a chemical etching process to thereby remove the sapphire substrate.

2. An LED chip production method as described in claim 1, wherein the nitride buffer layer is formed on the substrate in a thickness of from 20 nm to 300 nm, preferably of from 100 nm to 300 nm.

3. An LED chip production method as described in claim 1 or 2, wherein the at least one nitride semiconductor layer in the LED chip structure assembly has a structure with an n-type semiconductor layer, a light-emitting layer, and a p-type semiconductor layer, stacked in that order.

4. An LED chip production method as described in claim 3, wherein the thickness of the n-type semiconductor layer stacked on the nitride buffer layer is from 50 µm to 100 µm, preferably of from 70 µm to 90 µm.

5. An LED chip production method as described in claim 3 or 4, wherein the n-type semiconductor layer is an n-GaN layer, the light-emitting layer is an InGaN layer, and the p-type semiconductor layer is a p-GaN layer.

6. An LED chip production method as described in any one of claims 1 to 5, wherein a handling plate is adhered atop the at least one nitride semiconductor layer of the LED chip structure assembly subjected to the chemical etching process by means of an adhesive having oxidation resistance and alkali resistance.

7. An LED chip production method as described in claim 6, wherein the handling plate comprises a blue glass substrate with a greater diameter than the sapphire substrate of the LED chip structure assembly.

8. An LED chip production method as described in any one of claims 1 to 7, wherein the nitride buffer layer consists of aluminum nitride and the etchant is an alkali hydroxide solution, preferable a potassium hydroxide (KOH) solution or a sodium hydroxide (NaOH) solution.

9. An LED chip production method as described in any one of claims 1 to 8, wherein, following the chemical etching process of the nitride buffer layer, the chip structure assembly is washed with an organic solvent such as acetone.
